# FASCICULE DE BREVET EUROPEEN

(11) **EP 3 314 619 B1**
(45) Date de publication et mention de la délivrance du brevet: **17.07.2019**
(21) Numéro de dépôt: 16733430.9
(22) Date de dépôt: 24.06.2016
(51) Int. Cl.: H01F 17/00, H01F 27/28

(54) **TRANSFORMATEUR AMÉLIORÉ POUR UN CIRCUIT EN TECHNOLOGIE MMIC**
VERBESSERTER TRANSFORMATOR FÜR EINE SCHALTUNG IN MMIC-TECHNOLOGIE
IMPROVED TRANSFORMER FOR A CIRCUIT IN MMIC TECHNOLOGY

(30) Priorité: 25.06.2015 FR 1501335
(43) Date de publication de la demande: 02.05.2018
(73) Titulaire: Thales, 92400 Courbevoie (FR); Université de Bordeaux, 33000 Bordeaux (FR); Institut Polytechnique de Bordeaux, 33400 Talence (FR); Centre National de la Recherche Scientifique, 75016 Paris (FR)
(72) Inventeur: DUPUY, Victor, 78851 Elancourt Cedex (FR); MALLET-GUY, Benoît, 78851 Elancourt Cedex (FR); MANCUSO, Yves, 78851 Elancourt Cedex (FR); KERHERVE, Eric, 33600 Pessac (FR)
(74) Mandataire: Lavoix
(86) Numéro de dépôt international: PCT/EP2016/064745
(87) Numéro de publication internationale: WO 2016/207396

(56) Documents cités:
- US-A1- 2001 035 809
- US-A1- 2007 052 491

## Description

La présente invention concerne un transformateur pour un circuit en technologie MMIC, du type comportant une piste primaire et une piste secondaire, couplées l'une à l'autre par effet de mutuelle inductance, les pistes primaire et secondaire étant superposées l'une au-dessus de l'autre dans deux plans parallèles différents, tout en étant conformées de manière à suivre un même contour, le plan de la piste primaire correspondant à la couche conductrice principale du circuit, déposée sur un substrat, et la piste secondaire étant supportée, à l'aplomb de la piste primaire, par des moyens de support.

La technologie MMIC (selon l'acronyme anglais « Monolithic Microwave Integrated Circuit », ou encore « circuit intégré monolithique hyperfréquence »), GaN ou AsGa par exemple, prévoit de graver une couche métallique conductrice principale déposée sur un substrat.

Les deux principaux enjeux de l'intégration en technologie MMIC de transformateurs basés sur des inductances de type transformateur d'impédances et/ou baluns (pour « balanced-to-unbalanced transformer » en anglais, ou « transformateur symétrique-dissymétrique » en français) sont ceux de l'efficacité du transformateur et de son encombrement stérique. En effet, il convient de réaliser un transformateur à pertes minimales pour augmenter l'efficacité globale du système dans lequel il est implanté, mais aussi de réduire sa taille pour augmenter la compacité du système.

En plus de la fonction « transformateur symétrique-dissymétrique », un tel composant peut aussi faire office de transformateur d'impédance, notamment utilisable pour l'adaptation d'impédance lors de la combinaison d'amplificateurs de puissance.

Classiquement, en technologie MMIC, le circuit ne dispose que d'un unique niveau de métallisation disponible pour l'implémentation des motifs. Les transformateurs sont réalisés de manière planaire en disposant les deux enroulements l'un à côté de l'autre ou en les imbriquant l'un dans l'autre. Cette solution à le désavantage d'augmenter les pertes car le couplage planaire est peu propice au transfert d'énergie. Son encombrement est également important.

Il est connu, notamment pour permettre le croisement de pistes de manière à ce qu'elle n'entre pas en contact, de réaliser des ponts à air (« air bridge » en anglais). Un pont à air est constitué de deux piliers en un matériau conducteur prenant appui sur chacune des extrémités à connecter électriquement d'une piste interrompue pour franchir une autre piste. Les piliers supportent un pont, également réalisé en un matériau conducteur. Le pont est situé dans un plan parallèle au plan principal du circuit. Le diélectrique entre le pont et la couche métallique principale est simplement l'air du milieu environnant.

Le document US 2001/0035809 utilise ce principe des ponts à air pour réaliser un transformateur du type précité, dans lesquels les moyens de support de la piste secondaire sont constitués par des piliers et la piste secondaire par une succession de ponts en continuité électrique les uns avec les autres.

Un tel transformateur vertical est particulièrement intéressant du point de vue de l'intégration et de la facilité de réalisation.

Cependant, dans cette approche, l'enroulement secondaire réalisé à l'aide de ponts à air est soutenu par une multitude de piliers. L'enroulement primaire, qui est réalisé sur la couche métallique principale, présente des méandres pour contourner tous les piliers.

Cela réduit la surface en regard avec l'enroulement secondaire, ce qui diminue d'autant le couplage et donc le transfert d'énergie entre le primaire et le secondaire du transformateur.

Cela impose également de nombreux angles et une section efficace relativement réduite. Ceci n'est pas favorable au transfert d'énergie car le niveau de puissance pouvant traverser l'enroulement primaire est limité.

D'autre part, les ponts à air sont supportés par les piliers en des zones d'appui localisées et de faibles dimensions. Ceci peut engendrer des problèmes de stabilité mécanique de l'enroulement secondaire, voire d'effondrement de celui-ci lorsque le transformateur est soumis à des vibrations importantes. Il est alors nécessaire de réduire la portée des ponts, c'est-à-dire la distance entre deux piliers de support successifs. Mais ceci impose d'augmenter le nombre de piliers et, par conséquent, de réduire encore la largeur de l'enroulement primaire afin de pouvoir contourner aisément ces piliers.

Il est à noter des transformateurs verticaux existent en technologie Silicium, car celle-ci dispose de plusieurs niveaux de métallisation. Le problème de la création d'un deuxième plan conducteur ne se pose donc pas.

L'invention a donc pour but de palier aux problèmes précités, en proposant notamment un transformateur amélioré.

L'invention a pour objet un transformateur du type précité, caractérisé en ce que les moyens de support comportent au moins un muret, le muret prenant appui directement sur le substrat du circuit et sur une surface inférieure de la piste secondaire, une longueur du muret étant supérieure à une largeur du muret, et le muret présentant une hauteur permettant de ménager un intervalle prédéterminé entre une surface supérieure de la piste primaire et la surface inférieure de la piste secondaire.

Suivant des modes de réalisation particuliers, le transformateur comporte une ou plusieurs des caractéristiques suivantes, prise(s) isolément ou suivant toutes les combinaisons techniquement possibles :
- la piste primaire comporte une fenêtre présentant une longueur et une largeur respectivement supérieures à la longueur et à la largeur du muret, le muret traversant la fenêtre pour prendre appui directement sur le substrat.
- le muret est configuré pour suivre la section moyenne de la piste secondaire et la fenêtre suit la section moyenne de la piste primaire.
- les moyens de support comportent une paire de murets, les murets d'une paire de murets se faisant face selon la direction transversale audit contour et prenant appui sur le substrat de part et d'autre de la piste primaire.
- chaque muret d'une paire de murets est en contact de la surface inférieure de la piste secondaire, au voisinage du bord latéral de la piste secondaire, une largeur de la piste secondaire étant supérieure à une largeur de la piste primaire.
- les moyens de support comportent un muret renforcé propre à supporter une section de la piste secondaire au-dessous de laquelle ne se trouve aucune section correspondante de la piste primaire, la largeur d'un muret renforcé étant sensiblement égale à la largeur de la piste secondaire.
- la largeur de la piste secondaire est sensiblement égale à la largeur de la piste primaire de manière à maximiser une surface en regard des pistes entre elles.
- les bords latéraux de la piste primaire et/ou les bords latéraux de la piste secondaire sont rectilignes, une section selon une direction transversale au contour de la piste primaire et/ou de la piste secondaire étant sensiblement constante en tout point du contour.
- une piste parmi la piste primaire et la piste secondaire comporte une pluralité d'enroulements.
- le contour comporte au moins une boucle, de forme circulaire ou polygonale, comportant éventuellement des méandres.

L'invention sera mieux comprise et d'autres caractéristiques, buts et avantages de celle-ci apparaitront plus clairement à l'aide de la description qui va suivre de deux modes de réalisation particuliers de l'invention, donnés uniquement à titre illustratif et non limitatif, la description étant faite en référence aux dessins annexés, dans lesquels :
- La figure 1 représente schématiquement une vue de dessus d'un premier mode de réalisation du transformateur selon l'invention ;
- Les figures 2 et 3 représentent une coupe et une section du transformateur de la figure 1, respectivement selon la ligne longitudinale II-II et la ligne transversale III-III de la figure 1 ;
- La figure 4 représente schématiquement une vue de dessus d'un second mode de réalisation du transformateur selon l'invention ;
- Les figures 5 et 6 représentent une coupe et une section du transformateur de la figure 4, respectivement selon la ligne longitudinale V-V et la ligne transversale VI-VI de la figure 4.

### Premier mode de réalisation

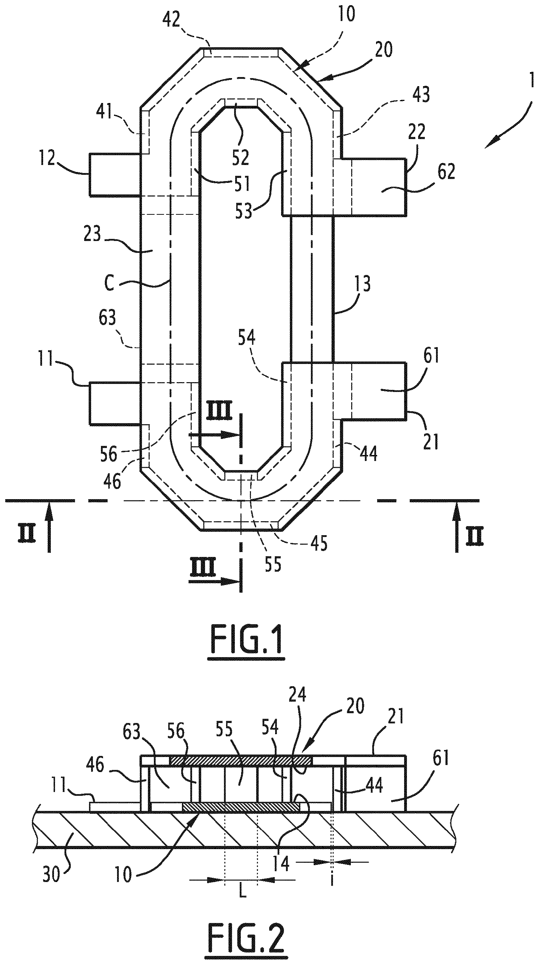

Les figures 1 à 3 représentent un transformateur selon un premier mode de réalisation.

Le transformateur 1 est destiné à être intégré dans un circuit en technologie MMIC.

Il comporte une piste primaire 10 et une piste secondaire 20. En fonctionnement, les pistes 10 et 20 sont couplées l'une à l'autre pas couplage inductif.

La piste primaire 10 est réalisée dans la couche métallique principale du circuit MMIC.

La piste primaire 10 s'étend entre deux sections d'extrémité 11 et 12 destinées à être connectée à des bornes de connexion du primaire du transformateur 1.

La piste primaire 10 est conformée de telle sorte qu'une section moyenne de la piste 10 suive un contour C, ayant la forme d'un octogone inscrit dans un ovoïde.

Dans ce qui suit, la direction principale correspond à la direction de la tangente au contour C au point considéré, et la direction transversale correspond à la direction perpendiculaire à la direction principale en ce point.

Transversalement au contour C, la piste primaire 10 présente une section rectangulaire d'épaisseur e1 et de largeur l1. Ces dimensions sont sensiblement constantes le long du contour C.

La piste secondaire 20 est située au-dessus de la piste primaire 10, dans un plan parallèle à celui de la couche principale. Elle est soutenue par des moyens de support.

La piste 20 s'étend entre deux sections d'extrémité 21 et 22 destinées à être connectée à des bornes de connexion du secondaire du transformateur 1.

La piste secondaire 20 est conformée de telle sorte qu'une section moyenne de la piste 20 suive le contour C.

Les extrémités de la piste secondaire 20 sont diamétralement opposées à celles de la piste primaire. En conséquence, une section intermédiaire 13 de la piste primaire 10, située entre les sections d'extrémité 21 et 22 de la piste secondaire 20 n'est pas recouverte par la piste secondaire 20. Réciproquement, une section intermédiaire 23 de la piste secondaire 20, située entre les sections d'extrémité 11 et 12 de la piste primaire 10 ne recouvre par la piste primaire 10.

Transversalement au contour C, la piste 20 présente une section rectangulaire d'épaisseur e2 et de largeur l2. Ces dimensions sont sensiblement constantes le long du contour C.

La largeur l2 de la piste secondaire 20 est légèrement supérieure à la largeur l1 de la piste primaire 10 de sorte que la piste secondaire 20 s'étend transversalement au-delà des bords latéraux de la piste primaire 10.

La piste secondaire 20 est réalisée en un matériau métallique, celui classiquement utilisé pour la réalisation de ponts à air en technologie MMIC.

Le transformateur 1 comporte, en tant que moyens de support de la piste secondaire, une pluralité de murets, chaque muret prenant appui directement sur le substrat 30 du circuit.

Un muret a une longueur L, selon une direction principale tangente au contour C, qui est supérieure à une largeur l, selon une direction transversale à la direction principale.

Les murets présentent une hauteur h commune permettant de ménager un intervalle prédéterminé entre une surface supérieure 14 de la piste primaire et une surface inférieure 24 de la piste secondaire.

Pour des raisons liées au procédé de fabrication, la partie inférieure d'un muret est constituée du métal de la couche principale du circuit. La partie supérieure d'un muret est constituée du matériau classiquement utilisé pour la réalisation des piliers des ponts à air. Entre la partie inférieure et la partie supérieure, un muret comporte une couche isolante, par exemple réalisée en un oxyde adapté, afin de ne pas réaliser de connexion électrique directe entre les deux pistes 10 et 20, la fonction de transformateur devant être réalisée uniquement par un couplage électromagnétique entre la piste primaire 10 et l'ensemble constitué par la piste secondaire et les parties supérieures des murets.

Dans le premier mode de réalisation, les murets vont par paires. La piste secondaire 20 est ainsi supportée par les paires 41, 51 ; 42, 52 ; 43, 53 ; 44, 54 ; 45, 55 et 46, 56.

Les murets d'une paire de murets sont disposés de part et d'autre de la piste primaire 10. Un intervalle i prédéterminé est ménagé entre la face d'un muret et le bord latéral en regard de la piste primaire 10, de manière à éviter tout contact électrique.

Puisque les murets supportent la piste secondaire 20 par en-dessous, la piste secondaire 20 doit être plus large que la piste primaire 10.

La piste primaire 10 se retrouve ainsi confinée à l'intérieur d'un tunnel formant le secondaire du transformateur. Avantageusement, les murets situés d'un même côté de la piste primaire 10 sont rapprochés les uns des autres, éventuellement de manière à former une cloison continue le long de tout ou partie du bord latéral correspondant de la piste primaire 10.

Le couplage électromagnétique entre le primaire et le secondaire est déterminé par la surface totale en vis-à-vis des deux pistes. Plus cette surface en vis-à-vis est grande, plus le couplage électromagnétique est important.

La partie supérieure des murets faisant partie du secondaire du transformateur, elle permet de limiter les fuites du champ magnétique généré par la circulation d'un courant dans la piste primaire 10 et, par conséquent, d'accroitre l'efficacité du transformateur, par rapport par exemple à celui du document US 2001/0035809.

Les moyens de support comportent également des murets renforcés 61, 62 et 63 propres à supporter une section de la piste secondaire 20 au-dessous de laquelle ne se trouve aucune section de la piste primaire 10. Il s'agit des sections d'extrémité 21 et 22 et de la section intermédiaire 23 de la piste secondaire 20 qui sont respectivement supportées par les murets renforcés 61, 62 et 63.

Un muret renforcé est un muret dont la largeur est sensiblement égale à celle de la piste secondaire 20. Avantageusement, un muret renforcé s'étend sur l'essentiel de la section de la piste secondaire 20 au-dessous de laquelle ne se trouve aucune section de la piste primaire 10, tout en conservant, dans le plan principal du circuit, un intervalle avec la piste primaire 10 permettant d'éviter tout contact électrique entre le muret renforcé et la piste primaire.

Avec de tels murets renforcés la résistance mécanique du transformateur 1, déjà améliorée par la présence des murets 41 à 56, est encore augmentée. Le transformateur ainsi obtenu est particulièrement résistant.

L'homme du métier constatera que les bords latéraux de la piste primaire 10 et/ou les bords latéraux de la piste secondaire 20 sont rectilignes et que la section selon une direction transversale au contour C de la piste primaire 10 et/ou de la piste secondaire 20 est sensiblement constante en tout point du contour C, et ceci, contrairement au document US 2001/0035809, où la piste primaire, tout au moins, comporte des échancrures latérales pour contourner les piliers et par conséquent présente une section dont les dimensions varient le long du contour suivi. Or une telle variation de la section dégrade les propriétés du transformateur, en particulier la puissance qu'il est possible de faire transiter au primaire et/ou au secondaire du transformateur.

En variante, le contour C peut prendre d'autres formes. Il peut notamment comporter des méandres de manière à réduire son encombrement latéral. Il peut également comporter plusieurs boucles.

Dans encore une autre variante, indépendante des précédentes, une piste peut être subdivisée de manière à être composée de plusieurs enroulements.

Avec la géométrie qui vient d'être présentée, la surface en regard entre les pistes du primaire et du secondaire est maximisée, d'où une amélioration de l'efficacité du transformateur.

### Second mode de réalisation

Dans ce second mode de réalisation, les éléments similaires à des éléments du premier mode de réalisation sont référencés par le chiffre de référence utilisé pour référencer cet élément similaire dans le premier mode de réalisation, augmenté d'une centaine.

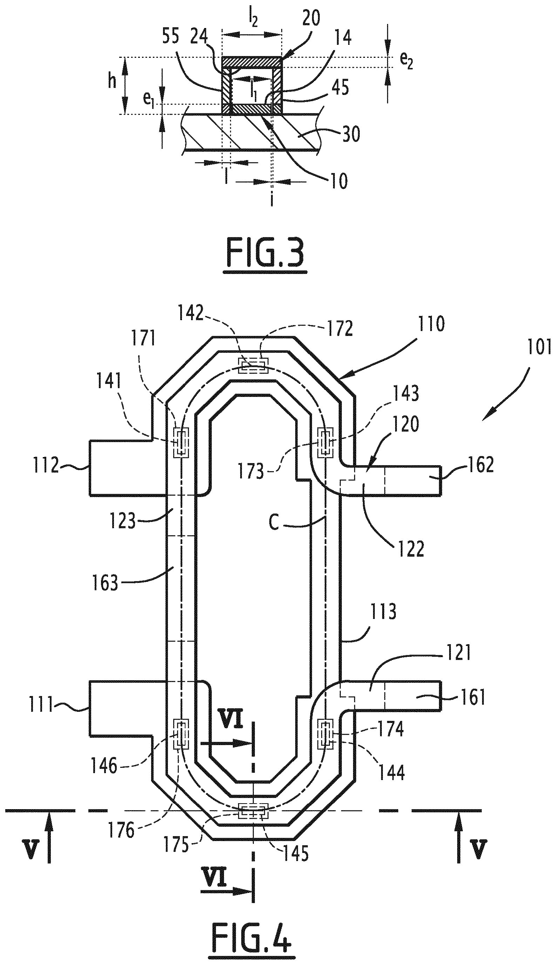

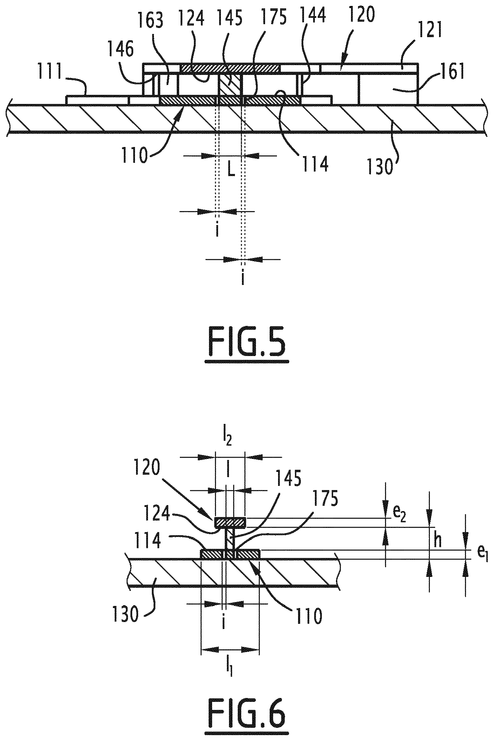

Les figures 4 à 6 représentent un transformateur selon un second mode de réalisation.

Le transformateur 101 est destiné à être intégré dans un circuit en technologie MMIC.

Il comporte une piste primaire 110 et une piste secondaire 120. En fonctionnement, les pistes 110 et 120 sont couplées l'une à l'autre pas inductance mutuelle.

La piste primaire 110 est réalisée dans la couche métallique principale du circuit MMIC.

La piste primaire 110 s'étend entre deux sections d'extrémité 111 et 112 destinées à être connectées à des bornes de connexion du primaire du transformateur 101.

La piste primaire 110 est conformée de telle sorte qu'une section moyenne de la piste 110 suive un contour C, ayant la forme d'un octogone inscrit dans un ovoïde.

Transversalement au contour C, la piste primaire 110 présente une section rectangulaire d'épaisseur e1 et de largeur l1. Ces dimensions sont sensiblement constantes le long du contour C.

La piste secondaire 120 est située au-dessus de la piste primaire 110, dans un plan parallèle à celui de la couche principale. Elle est soutenue par des moyens de support.

La piste 120 s'étend entre deux sections d'extrémité 121 et 122 destinées à être connectées à des bornes de connexion du secondaire du transformateur 101.

La piste secondaire 120 est conformée de telle sorte qu'une section moyenne de la piste 120 suive le contour C.

Les extrémités de la piste secondaire 120 sont diamétralement opposées à celles de la piste primaire 110. En conséquence, une section intermédiaire 113 de la piste primaire 110, située entre les sections d'extrémité 121 et 122 de la piste secondaire 120 n'est pas recouverte par la piste secondaire 120. Réciproquement, une section intermédiaire 123 de la piste secondaire 120, située entre les sections d'extrémité 111 et 112 de la piste primaire 110 ne recouvre par la piste primaire 110.

Transversalement au contour C, la piste 120 présente une section rectangulaire d'épaisseur e2 et de largeur l2. Ces dimensions sont sensiblement constantes le long du contour C.

La largeur l2 de la piste secondaire 120 est ici légèrement inférieure à la largeur l1 de la piste primaire 110 de sorte que la piste primaire 110 s'étend transversalement au-delà des bords latéraux de la piste secondaire 120.

La piste secondaire 120 est réalisée en un matériau métallique, celui classiquement utilisé pour la réalisation de ponts d'air en technologie MMIC.

Le transformateur 101 comporte, en tant que moyens de support de la piste secondaire, une pluralité de murets 141 à 146, chaque muret prenant appui directement sur le substrat 130.

Un muret a une longueur L, selon une direction principale tangente au contour C, qui est supérieure à une largeur l, selon une direction transversale à la direction principale.

Les murets présentent une hauteur h commune permettant de ménager un intervalle prédéterminé entre une surface supérieure 114 de la piste primaire 110 et une surface inférieure 124 de la piste secondaire 120.

Pour des raisons liées au procédé de fabrication, la partie inférieure d'un muret est constituée du métal de la couche principale du circuit. La partie supérieure d'un muret est constituée du matériau classiquement utilisé pour la réalisation des piliers des ponts à air. Entre la partie inférieure et la partie supérieure, un muret comporte une couche isolante, par exemple réalisée en un oxyde adapté, afin de ne pas réaliser de connexion électrique directe entre les deux pistes 110 et 120, la fonction de transformateur devant être réalisée uniquement par un couplage électromagnétique entre la piste primaire 110 et l'ensemble constitué par la piste secondaire 120 et les parties supérieures des murets.

Dans ce second mode de réalisation, les murets sont des murets centraux s'élevant depuis le substrat 130 et supportant la piste secondaire 120 au voisinage de sa section moyenne. La piste secondaire 120 est ainsi supportée par les murets 141, 142, 143, 144, 145, 146.

Pour éviter un contact entre un muret et la couche primaire 110, celle-ci est munie d'une découpe formant fenêtre 171 à 176. La piste 110 se subdivise en deux portions latérales de part et d'autre de la fenêtre.

Les dimensions longitudinales et transversales de cette fenêtre sont supérieures respectivement à la longueur L et à la largeur I du muret qui la traverse, de manière à ménager, de part et d'autre du muret, aussi bien selon la direction principale que selon la direction transversale, un intervalle i. Ainsi, l'intervalle i ménagé entre la face d'un muret et le bord en regard de la piste primaire 10 permet d'éviter tout contact électrique.

Dans ce second mode de réalisation, puisque les murets supportent la piste secondaire 20 par en-dessous, mais sensiblement le long de sa section moyenne, la largeur de la piste secondaire 20 n'est pas contrainte par celle de la piste primaire 10. Elle peut par exemple être plus étroite comme cela est représenté sur les figures 4 à 6. Mais, elle pourrait également être égale ou supérieure à la largeur de la piste primaire.

Les murets sont rapprochés les uns des autres, éventuellement de manière à former une cloison continue le long de tout ou partie de la section moyenne de la piste primaire 10.

Le couplage électromagnétique entre le primaire et le secondaire est déterminé par la surface totale en vis-à-vis des deux pistes. Plus cette surface en vis-à-vis est grande, plus le couplage électromagnétique est important.

La partie supérieure des murets faisant partie du secondaire du transformateur, elle permet de limiter les fuites du champ magnétique généré par la circulation d'un courant dans la piste primaire 10 et, par conséquent, d'accroitre l'efficacité du transformateur par rapport à celui du document US 2001/0035809. Cependant, ce second mode de réalisation est moins efficace que le premier, les murets étant placés au centre de la piste primaire 10 et non pas sur ses bords latéraux, là où les fuites sont maximales.

En variante, alors que dans le second mode de réalisation, le muret est disposé pour suivre la section moyenne de la piste secondaire 120 et la fenêtre pour suivre la section moyenne de la piste primaire, d'autres dispositions sont envisageables, en particulier une disposition dans laquelle un muret est implanté de manière à ce que sa longueur soit selon la direction transversale au contour C au niveau du point d'implantation de ce muret.

Les moyens de support comportent également des murets renforcés 161, 162 et 163 propres à supporter une section de la piste secondaire 120 au-dessous de laquelle ne se trouve aucune section correspondante de la piste primaire 110. Il s'agit des sections d'extrémité 121 et 122 et de la section intermédiaire 123 de la piste secondaire 120 qui sont respectivement supportées par les murets renforcés 161, 162 et 163.

Un muret renforcé est un muret dont la largeur est sensiblement égale à celle de la piste secondaire 120. Avantageusement, un muret renforcé s'étend sur l'essentiel de la section de la piste secondaire 120 au-dessous de laquelle ne se trouve aucune section de la piste primaire 110, tout en conservant, dans le plan principal du circuit, un intervalle avec la piste primaire 110 permettant d'éviter tout contact électrique entre le muret renforcé et la piste primaire.

Avec de tels murets renforcés la résistance mécanique du transformateur 101, déjà améliorée par la présence des murets 141 à 146, est encore augmentée. Le transformateur ainsi obtenu est particulièrement résistant.

## Revendications

1. Transformateur (1) pour un circuit en technologie MMIC, du type comportant une piste primaire (10) et une piste secondaire (20), couplées l'une à l'autre par effet de mutuelle inductance, les pistes primaire et secondaire étant superposées l'une au-dessus de l'autre dans deux plans parallèles différents, tout en étant conformées de manière à suivre un même contour (C), le plan de la piste primaire correspondant à la couche conductrice principale du circuit, déposée sur un substrat (30), et la piste secondaire étant supportée, à l'aplomb de la piste primaire, par des moyens de support, **caractérisé en ce que** les moyens de support comportent au moins un muret (4 à 46),
le muret prenant appui directement sur le substrat du circuit et sur une surface inférieure (24) de la piste secondaire (20),
une longueur (L) du muret étant supérieure à une largeur (l) du muret, et,
le muret présentant une hauteur (h) permettant de ménager un intervalle prédéterminé entre une surface supérieure (14) de la piste primaire (10) et la surface inférieure (24) de la piste secondaire (20).

2. Transformateur (101) selon la revendication 1, dans lequel la piste primaire (110) comporte une fenêtre (171 à 176) présentant une longueur et une largeur respectivement supérieures à la longueur (L) et à la largeur (l) du muret, le muret (141 à 146) traversant la fenêtre pour prendre appui directement sur le substrat (30).

3. Transformateur (101) selon la revendication 2, dans lequel le muret (141 à 146) est configuré pour suivre la section moyenne de la piste secondaire (120) et la fenêtre (171 à 176) suit la section moyenne de la piste primaire (110).

4. Transformateur (1) selon la revendication 1, dans lequel les moyens de support comportent une paire de murets (41, 51 ; 42, 52 ; 43, 53 ; 44, 54 ; 45, 55 ; 46, 56), les murets d'une paire de murets se faisant face selon la direction transversale audit contour (C) et prenant appui sur le substrat de part et d'autre de la piste primaire (10).

5. Transformateur (1) selon la revendication 4, dans lequel chaque muret d'une paire de murets est en contact de la surface inférieure (24) de la piste secondaire (20), au voisinage du bord latéral de la piste secondaire (20), une largeur de la piste secondaire (20) étant supérieure à une largeur de la piste primaire (10).

6. Transformateur (1) selon l'une quelconque des revendications précédentes, dans lequel les moyens de support comportent un muret renforcé (61, 62, 63) propre à supporter une section de la piste secondaire (20) au-dessous de laquelle ne se trouve aucune section correspondante de la piste primaire (10), la largeur d'un muret renforcé étant sensiblement égale à la largeur de la piste secondaire (20).

7. Transformateur selon l'une quelconque des revendications précédentes, dans lequel la largeur de la piste secondaire (20) est sensiblement égale à la largeur de la piste primaire (10) de manière à maximiser une surface en regard des pistes entre elles.

8. Transformateur (1) selon l'une quelconque des revendications précédentes, dans lequel les bords latéraux de la piste primaire (10) et/ou les bords latéraux de la piste secondaire (20) sont rectilignes, une section selon une direction transversale au contour (C) de la piste primaire (10) et/ou de la piste secondaire (20) étant sensiblement constante en tout point du contour (C).

9. Transformateur selon l'une quelconque des revendications précédentes, dans lequel une piste parmi la piste primaire et la piste secondaire comporte une pluralité d'enroulements.

10. Transformateur selon l'une quelconque des revendications précédentes, dans lequel le contour comporte au moins une boucle, de forme circulaire ou polygonale, comportant éventuellement des méandres.

## Patentansprüche

1. Transformator (1) für einen Schaltkreis in MMIC-Technologie, des Typs aufweisend eine primäre Bahn (10) und eine sekundäre Bahn (20), die via Gegenseitige-Induktivität-Wirkung miteinander verbunden sind, wobei die primäre und die sekundäre Bahn übereinander angeordnet sind in zwei verschiedenen, parallelen Ebenen, wobei sie angepasst sind, um einer gleichen Kontur (C) zu folgen, wobei die Ebene der primären Bahn zu der Hauptleitungsschicht des Schaltkreises korrespondiert, die auf einem Substrat (30) angeordnet ist, und wobei die sekundäre Bahn von Haltemitteln im Lot der primären Bahn gehalten ist, **dadurch gekennzeichnet, dass** die Haltemittel wenigstens eine Mauer (4 bis 46) aufweisen,
wobei die Mauer sich direkt auf dem Substrat des Schaltkreises und auf einer unteren Fläche (24) der sekundären Bahn (20) abstützt,
wobei eine Länge (L) der Mauer größer als eine Breite (l) der Mauer ist, und
wobei die Mauer eine Höhe (h) hat, die es ermöglicht, einen vorbestimmten Abstand zwischen einer oberen Fläche (14) der primären Bahn (10) und der unteren Fläche (24) der sekundären Bahn (20) einzurichten.

2. Transformator (101) gemäß Anspruch 1, wobei die primäre Bahn (110) ein Fenster (171 bis 176) aufweist, das eine Länge und eine Breite hat, die respektive größer sind als die Länge (L) und die Breite (l) der Mauer, wobei die Mauer (141 bis 146) das Fenster durchdringt, um sich direkt auf dem Substrat (30) abzustützen.

3. Transformator (101) gemäß Anspruch 2, wobei die Mauer (141 bis 146) konfiguriert ist, um dem Mittelabschnitt der sekundären Bahn (120) zu folgen, wobei das Fenster (171 bis 176) dem Mittelabschnitt der primären Bahn (110) folgt.

4. Transformtor (1) gemäß Anspruch 1, wobei die Haltemittel ein Paar Mauern (41, 51; 42, 52; 43, 53; 44, 54; 45, 55; 46, 56) aufweisen, wobei die Mauern eines Paars Mauern sich entlang der Richtung quer zur Kontur (C) einander gegenüberliegen und sich beidseitig der primären Bahn (10) auf dem Substrat abstützen.

5. Transformator (1) gemäß Anspruch 4, wobei jede Mauer eines Paars Mauern benachbart zum seitlichen Rand der sekundären Bahn (20) in Kontakt ist mit der unteren Fläche (24) der sekundären Bahn (20), wobei eine Breite der sekundären Bahn (20) größer ist als eine Breite der primären Bahn (10).

6. Transformator (1) gemäß irgendeinem der vorhergehenden Ansprüche, wobei die Haltemittel eine Verstärkungsmauer (61, 62, 63) aufweisen, die imstande ist, einen Abschnitt der sekundären Bahn (20) zu stützen, unter welchem sich kein korrespondierender Abschnitt der primären Bahn (10) befindet, wobei die Breite einer Verstärkungsmauer im Wesentlichen gleich der Breite der sekundären Bahn (20) ist.

7. Transformator gemäß irgendeinem der vorhergehenden Ansprüche, wobei die Breite der sekundären Bahn (20) im Wesentlichen gleich der Breite der primären Bahn (10) ist, um eine gegenüberliegende Fläche der Bahnen zwischen sich zu maximieren.

8. Transformator (1) gemäß irgendeinem der vorhergehenden Ansprüche, wobei die seitlichen Ränder der primären Bahn (10) und/oder die seitlichen Ränder der sekundären Bahn (20) geradlinig sind, wobei ein Querschnitt entlang einer Richtung quer zur Kontur (C) der primären Bahn (10) und/oder der sekundären Bahn (20) an jedem Punkt der Kontur (C) im Wesentlichen konstant ist.

9. Transformator gemäß irgendeinem der vorhergehenden Ansprüche, wobei eine Bahn von der primären Bahn und der sekundären Bahn eine Mehrzahl von Windungen hat.

10. Transformator gemäß irgendeinem der vorhergehenden Ansprüche, wobei die Kontur wenigstens eine Schleife mit einer kreis- oder polygonalen Form aufweist, die gegebenenfalls Mäander aufweist.

## Claims

1. A transformer (1) for a circuit in MMIC technology, of the type including a primary track (10) and a secondary track (20) that are coupled to one another by mutual inductance, the primary and secondary tracks being superimposed on top of each other in two different parallel planes, while being arranged so as to follow a same contour (C), the plane of the primary track corresponding to the main conductive layer of the circuit, deposited on a substrate (30), and the secondary track being supported, plumb with the primary track, by supporting means, **characterized in that** the supporting means comprises at least one wall (4 to 46),
the wall bearing directly on the substrate of the circuit and on a lower surface (24) of the secondary track (20),
a length (L) of the wall being greater than a width (I) of the wall, and
the wall having a shared height (h) making it possible to arrange a predetermined interval between an upper surface (14) of the primary track (10) and the lower surface (24) of the secondary track (20).

2. The transformer (101) according to claim 1, wherein the primary track (110) includes a window (171 to 176) having a length and a width respectively larger than the length (L) and the width (I) of the wall, the wall (141 to 146) traversing the window to bear directly on the substrate (30).

3. The transformer (101) according to claim 2, wherein the wall (141 to 146) is configured to follow the average section of the secondary track (120) and the window (171 to 176) follows the average section of the primary track (110).

4. The transformer (1) according to claim 1, wherein the supporting means includes a pair of walls (41, 51; 42, 52; 43, 53; 44, 54; 45, 55; 46, 56), the walls of a pair of walls facing one another along the direction transverse to said contour (C) and bearing on the substrate on either side of the primary track (10).

5. The transformer (1) according to claim 4, wherein each wall of a pair of walls is in contact with the lower surface (24) of the secondary track (20), near the lateral edge of the secondary track (20), a width of the secondary track (20) being greater than a width of the primary track (10).

6. The transformer (1) according to any one of the preceding claims, wherein the supporting means include a reinforced wall (61, 62, 63) able to support a section of the secondary track (20) below which there is no corresponding section of the primary track (10), the width of a reinforced wall being substantially equal to the width of the secondary track (20).

7. The transformer according to any one of the preceding claims, wherein the width of the secondary track (20) is substantially equal to the width of the primary track (10) so as to maximize a facing surface of the tracks with respect to one another.

8. The transformer (1) according to any one of the preceding claims, wherein the lateral edges of the primary track (10) and/or the lateral edges of the secondary track (20) are rectilinear, a section along a direction transverse to the contour (C) of the primary track (10) and/or the secondary track (20) being substantially constant at all points of the contour (C).

9. The transformer according to any one of the preceding claims, wherein one track from among the primary track and the secondary track includes a plurality of windings.

10. The transformer according to any one of the preceding claims, wherein the contour includes at least one loop, circular or polygonal, optionally including meanders.
